# EUROPEAN PATENT APPLICATION

(11) **EP 4 663 403 A1**
(43) Date of publication of application: **17.12.2025**
(21) Application number: 23874056.7
(22) Date of filing: 29.03.2023
(51) Int. Cl.: B32B 9/00, C23C 14/16, C25D 7/06, B32B 9/04, H01M 4/36

(54) **LITHIUM-CARBON COMPOSITE BAND AND PREPARATION METHOD THEREFOR**

(30) Priority: 10.02.2023 CN 202310104236
(71) Applicant: China Energy Lithium Co., Ltd., Tianjin 300457 (CN)
(72) Inventor: KONG, Deyu, Tianjin 300457 (CN); CHEN, Qiang, Tianjin 300457 (CN); MU, Hanbo, Tianjin 300457 (CN); HUAN, Qingna, Tianjin 300457 (CN); SUN, Zhaoyong, Tianjin 300457 (CN); WANG, Weizhou, Tianjin 300457 (CN)
(74) Representative: Witte, Weller & Partner Patentanwälte mbB
(86) International application number: PCT/CN2023/084678
(87) International publication number: WO 2024/164411

(57) **Abstract**

The present application provides a lithium carbon composite belt and a preparation method therefor. The lithium carbon composite belt comprises a substrate, a metal lithium transition layer on each side of the substrate, and a lithium carbon composite material layer on an outer layer of the metal lithium transition layer, wherein a mass fraction of carbon in the lithium carbon composite material layer is in a range from 5% to 90%. The substrate layer of the lithium carbon composite belt provides high tensile performance for the lithium carbon composite belt, which is suitable for large scale industrial production. The metal lithium transition layer makes the substrate layer tightly bound with the lithium carbon composite material layer, avoiding the problem of forming bumps during the production of the lithium carbon composite belt. The presence of the metal lithium transition layer can effectively reduce the internal resistance of the lithium carbon composite belt. The lithium in the transition layer is active lithium, and thus can also participate in the battery cycling process, so as to compensate the consumption of the metal lithium in the lithium carbon layer. The lithium carbon composite material layer contains a carbon skeleton, which can not only provide a reserved space for metal lithium deposition, inhibiting the volume change of the metal lithium during the cycling, but also effectively reduce local current density on an electrode, preventing the formation of lithium dendrites.

## Description

### Technical Field

The present application relates to the field of metal lithium processing, and particularly to a lithium carbon composite belt and a preparation method therefor.

### Background

Metal lithium as a negative electrode material with great application prospect in the future has been a research focus in the lithium battery field. Pure metal lithium has been hindered on the road to industrialization due to the problems of its relatively large volume change and its tendency to produce lithium dendrites during cycling.

In order to overcome the problems existed in pure metal lithium, other materials are combined with metal lithium to obtain a composite material with superior performances so as to meet the requirements of lithium batteries on high energy density and long cycle life. Here, the combination of inexpensive and widely existed carbon materials with metal lithium is a research focus. The lithium carbon composite material can solve the problem of volume change of an electrode and inhibit the formation of lithium dendrites during cycling, but after adding a carbon material into pure metal lithium, especially in a high amount, the lithium carbon material will have a low tensile strength, be not easy to process, and also be not easy to adhere onto the current collector substrate. In order to increase the binding force between the lithium carbon material and the current collector substrate, a rolling device with a relatively large pressure is generally used for binding, but the phenomena of forming bumps and separation of the current collector from the lithium carbon material may occur easily, which will result in rapid deterioration in performances of the lithium carbon material during battery cycling, and in turn influence the cycle life of the battery.

Thus, there is a need for a lithium carbon composite belt having a high tensile strength, in which a lithium carbon material is tightly bound on a substrate.

### Summary

In view of the above problems, the present application provides a lithium carbon composite belt having a high tensile strength in which a lithium carbon material is tightly bound on a substrate, wherein a metal lithium transition layer is provided between the substrate layer and the lithium carbon material layer. While using the substrate layer to provide high tensile strength for the lithium carbon composite belt, the metal lithium transition layer bound in situ prevents the problem that the substrate layer is not easy to be tightly bound with the lithium carbon layer and thereby easily forming bumps. The presence of the metal lithium transition layer can also effectively reduce the internal resistance of the lithium carbon composite belt. The lithium in this layer is active lithium, and thus can also participate in the battery cycling process, so as to compensate the consumption of the metal lithium in the lithium carbon material layer.

In order to achieve the above object, in an aspect, the present application provides a lithium carbon composite belt comprising:
a conductive substrate,
a metal lithium transition layer on each side of the substrate, and
a lithium carbon composite material layer on an outer side of the metal lithium transition layer, wherein the lithium carbon composite material comprises a porous carbonaceous skeleton and metal lithium filled in pores of the porous carbonaceous skeleton, and a mass fraction of carbon in the lithium carbon composite material layer is in a range from 5% to 90%, and preferably from 15% to 65%.

In some embodiments, the substrate is a metal foil, an organic polymer film, an inorganic material film or any composite film thereof.

In some embodiments, the metal foil is a foil obtained from aluminum, copper, nickel, tin, platinum, gold, silver, iron, lead, titanium, indium, zinc, magnesium, beryllium, tungsten, sodium, antimony or any combination thereof. For example, the metal foil is a copper foil, an aluminum foil, a nickel foil, a stainless steel foil, a perforated copper foil, a woven copper mesh, or a stainless steel mesh.

In some embodiments, the organic polymer film is a film prepared from a polyolefin, a polyester, or a modified polymer containing one or more functional groups selected from the group consisting of amino, carboxyl, hydroxyl, imino, halogen, sulfo, nitro, mercapto, phenyl, and cyano. For example, the organic polymer film is a polyethylene film, a polypropylene film, a polyacrylonitrile film, a polyethylene terephthalate film, or any of the aforementioned films with holes.

In some embodiments, the inorganic material film comprises a film obtained from an inorganic carbon material, a metal oxide, a metal halide, a metal nitride, a metal sulfide, a metal salt or any combination thereof. For example, the inorganic material film is a carbon fiber film, a graphene film, a carbon nanotube film, or a buckypaper.

In some embodiments, the composite film is a polyacrylonitrile film plated with copper on a surface thereof, a copper foil plated with an oxide on a surface thereof, a copper mesh plated with silver on a surface thereof, or a stainless steel mesh plated with lithium on a surface thereof.

In some embodiments, the substrate has a thickness in a range from 1 µm to 20 µm and a porosity in a range from 0% to 85%, for example, from 15% to 85%.

In some embodiments, the metal lithium transition layer has a thickness in a range from 20 nm to 5 µm, and preferably from 1 µm to 5 µm.

In some embodiments, the lithium carbon composite material layer has a thickness in a range from 1 µm to 200 µm, and preferably from 5 µm to 50 µm.

In some embodiments, the porous carbonaceous skeleton of the lithium carbon composite material is a network skeleton which is formed by intertwining a carbon composite material and has a lithiophilic modification layer, wherein the carbon composite material comprises a crystalline carbonaceous material and an amorphous carbonaceous wrapping layer covering a surface of the crystalline carbonaceous material, and the amorphous carbonaceous wrapping layer forms the lithiophilic modification layer.

In some embodiments, the crystalline carbonaceous material comprises one or more selected from the group consisting of carbon nanotubes, graphene, pyrolytic carbon fibers, graphite, soft carbon, hard carbon, mesocarbon microspheres, and carbon black.

In some embodiments, the amorphous carbonaceous wrapping layer is a carbonized product of an organic material which is blended with the crystalline carbonaceous material, wherein the organic material is selected from the group consisting of an organic binder, an organic filler, and a crosslinker,
In some embodiments, the amorphous carbonaceous wrapping layer has a thickness in a range from 10 nm to 600 nm.

In some embodiments, the amorphous carbonaceous wrapping layer further comprises metal nanoparticles embedded therein or on a surface thereof, wherein the metal nanoparticles have a size in a range from 5 nm to 800 nm.

In some embodiments, the porous carbonaceous skeleton in the lithium carbon composite material layer has a linear, spherical, urchin-shaped, porous spherical, spheroidal or flat structure.

In another aspect, the present application provides a method for preparing the lithium carbon composite belt as described above, the method being carried out under an atmosphere of an inert gas, and comprising:
Step I: pretreating a substrate, including subjecting the substrate to at least one of degreasing, pre-oxidizing, plasma purging, ultrasonic cleaning and high temperature treatment;
Step II: building a metal lithium transition layer, including in situ building the metal lithium transition layer on a surface of the substrate by rolling, doctor blade coating, extrusion coating, physical vapor deposition, or electroplating; and
Step III: building a lithium carbon composite material layer, including combining a lithium carbon composite material with the metal lithium transition layer by doctor blade coating, extrusion coating, or pressure binding, so as to obtain the lithium carbon composite belt.

In some embodiments, the inert gas comprises argon or high purity helium.

In some embodiments, the lithium carbon composite material is prepared by:
Step 1: mixing an organic binder, a filler, a crosslinker and a solvent uniformly to obtain a mixture, wherein the filler comprises a crystalline carbonaceous material, an organic filler and optionally an inorganic filler;
Step 2: pre-drying the mixture obtained in Step 1 to remove the solvent;
Step 3: heating the material obtained in Step 2 under an inert atmosphere at a temperature in a range from 300°C to 1200°C and then cooling the material to obtain a porous carbonaceous skeleton; and
Step 4: impregnating the porous carbonaceous skeleton obtained in Step 3 with molten lithium to obtain a lithium carbon composite material.

In some embodiments, a mass ratio of the organic binder, the filler, the crosslinker and the solvent is (4-15 parts): (10-30 parts): (0.01-20 parts): (20-400 parts).

In some embodiments, a mass proportion of the crystalline carbonaceous material in the filler is in a range from 15% to 100%.

In some embodiments, the organic binder is selected from the group consisting of polyvinyl alcohol, polyvinylidene fluoride, polybutylene styrene, polystyrene, polycarboxycellulose, cyanoacrylates, polyacrylic acid, cyclodextrins, cyclic ether derivatives, polyurethanes, methacrylates, epoxy resins, vinyl acetate polymer, polyimides, organic fluoropolymers, organosiloxanes, polyethylene glycol, polyethylene, polyvinyl chloride, polypropylene, glycerin, ethylparaben and its derivatives, and monosaccharide or polysaccharide polymers.

In some embodiments, the organic filler is selected from the group consisting of plastic microparticles (such as polypropylene, polyethylene terephthalate, and polystyrene), benzoic acid, sodium benzoate, sorbic acid, potassium sorbate, calcium propionate, and dehydroacetates.

In some embodiments, the inorganic filler is selected from the group consisting of metal nanoparticles, metal oxides, metal nitrides, calcium carbonate, hydrous magnesium silicate, mica, hydrated silica, and silica.

In some embodiments, the crosslinker is selected from the group consisting of macromolecular polymers of acrylic acid bonded with allyl sucrose or pentaerythritol allyl ether, benzoyl peroxide, diethylenetriamine, sodium borate hydrate, cellulose derivatives, and isothiazolinone.

In some embodiments, the solvent is selected from the group consisting of water, tetrachloroethylene, toluene, turpentine, acetone, methyl acetate, ethyl acetate, pentane, n-hexane, cyclohexane, octane, lemonile (lemon nitrile), alcohol, xylene, toluene, cyclohexanone, isopropyl alcohol, diethyl ether, propylene oxide, methyl butanone, ethylene glycol monomethyl ether, ethylene glycol monoethyl ether, ethylene glycol monobutyl ether, acetonitrile, pyridine, phenol, and ethylenediamine.

The lithium carbon composite belt provided by the present application at least has one of the following advantages.
1, The substrate layer of the lithium carbon composite belt provides high tensile performance for the lithium carbon composite belt, which is suitable for large scale industrial production.
2, The metal lithium transition layer of the lithium carbon composite belt makes the substrate layer tightly bound with the lithium carbon composite material layer, avoiding the problem of forming bumps during the production of the lithium carbon composite belt.
3, The presence of the metal lithium transition layer can effectively reduce the internal resistance of the lithium carbon composite belt. The lithium in the metal lithium transition layer is active lithium, and thus can also participate in the battery cycling process, so as to compensate the consumption of the metal lithium in the lithium carbon composite material layer.
4, The lithium carbon composite material layer of the lithium carbon composite belt contains a porous carbonaceous skeleton, which can not only provide a reserved space for metal lithium deposition, inhibiting the volume change of the metal lithium during the cycling, but also reduce local current density on an electrode, preventing the formation of lithium dendrites.

### Brief Description of Drawings

Fig. 1 is a schematic diagram of the structure of the lithium carbon composite belt of the present application.
Fig. 2 shows the lithium carbon composite belt prepared in Example 1.
Fig. 3 shows the lithium carbon composite belt prepared in Example 6.
Fig. 4 shows the lithium carbon composite belt prepared in Example 7.
Fig. 5 shows the lithium carbon composite belt prepared in Example 8.
Fig. 6 shows the lithium carbon composite belt prepared in Example 9.
Fig. 7 shows the lithium carbon composite belt prepared in Comparative Example 2.
Fig. 8 shows the cycling curves of the cells assembled with the materials of Example 1, Comparative Example 2 and Comparative Example 3 respectively.

### Detailed Description

In order to make the objects, technical solutions and advantages of the present application more clear and apparent, the present application will be further described in detail below with reference to drawings and examples. It should be appreciated that the particular examples described here are only intended to explain, but not to limit the present application. Technical features involved in various examples of the present application described below can be combined with each other, as long as they do not conflict with each other.

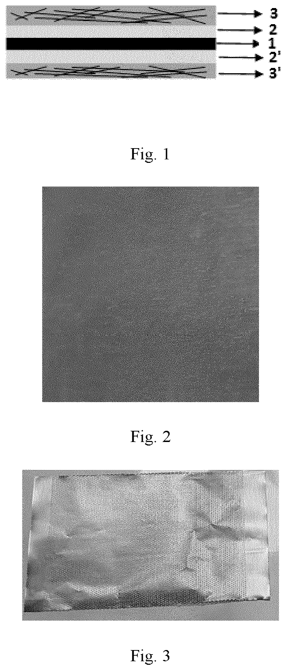

A representative structure of the lithium carbon composite belt of the present application, as shown in Fig. 1, comprises: a substrate 1, metal lithium transition layers 2, 2' respectively bound on each side of the substrate 1, and lithium carbon composite material layers 3, 3' laminated on the metal lithium transition layers. The thicknesses of the metal lithium transition layers 2, 2' respectively on each side of the substrate 1 may be the same or different, and the processes for forming the metal lithium transition layers may be the same or different. Similarly, the lithium carbon composite material layers 3, 3' on each side may be the same or different. Preferably, the metal lithium transition layer 2 and the metal lithium transition layer 2' are the same, and the lithium carbon composite material layer 3 and the lithium carbon composite material layer 3' are the same.

### Example 1

### Pretreatment on the substrate

A copper foil with a thickness of 6 µm was cleaned with a rotary plasma cleaner (Shenzhen Tonson Tech Automation Equipment Co., Ltd.) to obtain a dust-free copper foil substrate.

### Building the metal lithium transition layer

A layer of metal lithium with a thickness of 4 µm was deposited on the surface of the copper foil by physical vapor deposition. During the physical vapor deposition, the chamber had a vacuum degree of 5.0 × 10⁻³ Pa and a temperature of 650°C, with a temperature control accuracy of ±2°C.

### Building the lithium carbon layer

Polyvinyl alcohol (Aladdin Scientific Corp., Shanghai), polystyrene microspheres (Suzhou Weimai Novel Material Co. Ltd.), carbon nanotubes (Shandong Dazhan), diethylenetriamine (Shanghai Yantai Industrial Co. Ltd.), isothiazolinone (Aladdin Scientific Corp., Shanghai), silver nanoparticles and deionized water were uniformly mixed in a mass ratio of 6:9:9:5:5:2:75.

The mixture prepared was pre-dried at 85°C for 5 hours. The pre-dried material was placed in a crucible, and subjected to a high temperature treatment at 1000°C under an inert atmosphere for 5 hours to obtain a carbon skeleton material. The carbon skeleton material prepared above was contacted with molten metal lithium, and the metal lithium was impregnated into the carbon material. After cooling, a lithium carbon block having a 3D carbon skeleton was obtained. The lithium carbon block was turned, rolled and cut to obtain a lithium carbon composite belt with a thickness of 50 µm.

The lithium carbon composite belt prepared above was pressure bound with the copper foil having metal lithium deposited on its surface by rolling (at a pressure of 2 MPa) to obtain a lithium carbon composite belt with a thickness of 60 µm. The lithium carbon composite belt prepared is as shown in Fig. 2. The outer lithium carbon layer was tightly adhered onto the copper foil substrate, and the lithium carbon layer had a smooth surface without any bump.

### Example 2

### Pretreatment on the substrate

A roll of PET (polyethylene terephthalate) film with a thickness of 6 µm was used as the substrate. The roll of PET film was firstly dried in a vacuum oven at 80°C for 24 hours.

### Building the metal transition layer

A lithium layer with a thickness of 4 µm was deposited on each of the upper and lower surfaces of the roll of PET film in a vacuum evaporation deposition device (with a vacuum degree of 10⁻³ Pa at a temperature of 500°C).

### Building the lithium carbon layer

The lithium carbon belt prepared in Example 1 was bound with the PET film having metal lithium deposited on its surface by rolling to obtain a lithium carbon composite belt with a thickness of 60 µm.

### Example 3

The implementation of Example 3 was the same as that of Example 2 only except that the substrate was changed to a polyacrylonitrile film with copper plated on its surface.

### Example 4

The implementation of Example 4 was the same as that of Example 2 only except that tin tetrachloride was added into the polyacrylonitrile film.

### Example 5

The implementation of Example 5 was the same as that of Example 2 only except that the substrate was changed to a polyacrylonitrile film with alumina coated on its surface.

### Example 6

The implementation of Example 6 was the same as that of Example 1 only except that the substrate was changed to a perforated copper, as shown in Fig. 3.

### Example 7

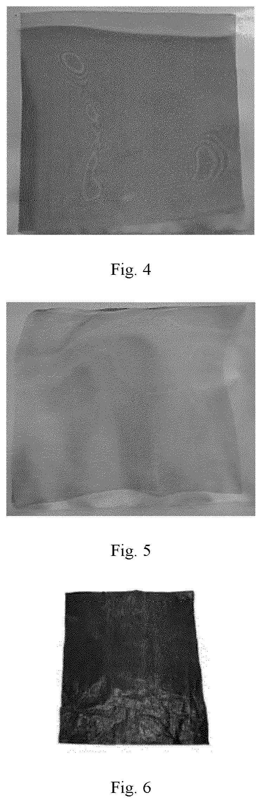

The implementation of Example 7 was the same as that of Example 1 only except that the substrate was changed to a woven copper mesh, as shown in Fig. 4.

### Example 8

The implementation of Example 8 was the same as that of Example 1 only except that the substrate was changed to a stainless steel mesh, as shown in Fig. 5.

### Example 9

The implementation of Example 9 was the same as that of Example 1 only except that the substrate was changed to a carbon nanotube paper, as shown in Fig. 6.

### Example 10

The implementation of Example 10 was the same as that of Example 1 only except that the substrate was changed to a graphene paper.

### Comparative Example 1

Polyvinyl alcohol (Aladdin Scientific Corp., Shanghai), polystyrene microspheres (Suzhou Weimai Novel Material Co. Ltd.), carbon nanotubes (Shandong Dazhan), diethylenetriamine (Shanghai Yantai Industrial Co. Ltd.), isothiazolinone (Aladdin Scientific Corp., Shanghai), silver nanoparticles and deionized water were uniformly mixed in a mass ratio of 6:9:9:5:5:2:75.

The mixture prepared was pre-dried at 85°C for 5 hours. The pre-dried material was placed in a crucible, and subjected to a high temperature treatment at 1000°C under an inert atmosphere for 5 hours to obtain a carbon skeleton material. The carbon skeleton material prepared above was contacted with molten metal lithium, and the metal lithium was impregnated into the carbon material. After cooling, a lithium carbon block having a 3D carbon skeleton was obtained. The lithium carbon block was turned, rolled and cut to obtain a lithium carbon belt with a thickness of 60 µm.

### Comparative Example 2

### Pretreatment on the substrate

A copper foil with a thickness of 6 µm was cleaned with a rotary plasma cleaner (Shenzhen Tonson Tech Automation Equipment Co., Ltd.) to obtain a dust-free copper foil substrate.

### Building the lithium carbon layer

Polyvinyl alcohol (Aladdin Scientific Corp., Shanghai), polystyrene microspheres (Suzhou Weimai Novel Material Co. Ltd.), carbon nanotubes (Shandong Dazhan), diethylenetriamine (Shanghai Yantai Industrial Co. Ltd.), isothiazolinone (Aladdin Scientific Corp., Shanghai), silver nanoparticles and deionized water were uniformly mixed in a mass ratio of 6:9:9:5:5:2:75.

The mixture prepared was pre-dried at 85°C for 5 hours. The pre-dried material was placed in a crucible, and subjected to a high temperature treatment at 1000°C under an inert atmosphere for 5 hours to obtain a carbon skeleton material. The carbon skeleton material prepared above was contacted with molten metal lithium, and the metal lithium was impregnated into the carbon material. After cooling, a lithium carbon composite block having a 3D carbon skeleton was obtained. The lithium carbon composite block was turned, rolled and cut to obtain a lithium carbon composite belt with a thickness of 54 µm.

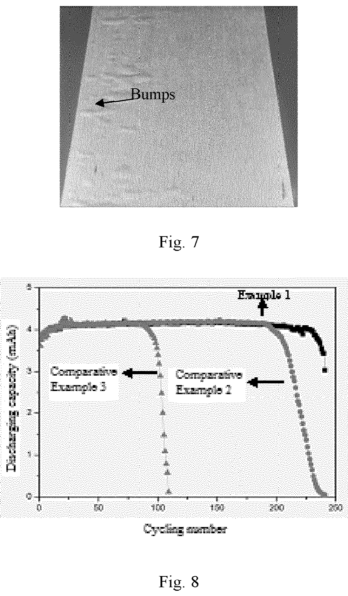

The lithium carbon composite belt prepared above was pressure bound with the pretreated copper foil by rolling (at a pressure of 2 MPa) to obtain a lithium carbon composite belt with a thickness of 60 µm. The lithium carbon composite belt prepared is as shown in Fig. 7. The lithium carbon composite belt had bumps on its surface, and the lithium carbon layer was not tightly attached onto the substrate.

### Comparative Example 3

The steps of Comparative Example 3 were the same as those of Example 1 only except that a 50 µm pure lithium belt was pressure bound (at a pressure of 2 MPa) with a copper foil with metal lithium deposited on its surface to obtain a lithium copper composite belt.

### Peeling force test:

Test specimens with a width of 25 mm and a length of 150 mm were prepared from the belts prepared in the Examples, with 5 test specimens for each Example. A TESA 7475 adhesive tape (Tesa Tape, Inc.) was attached to the testing surface of the test specimen, and rolled back and forth twice with a 2 kg standard roller. The non-testing surface of the test specimen was fixed onto a standard stainless steel plate via a double sided adhesive tape for further testing. One end of the adhesive tape was peeled off from the stainless steel, the stainless steel plate was clamped by a lower jig, and the end with the adhesive tape was clamped by an upper jig. The test was configured to be performed at a tester speed of 30 mm/min and a drawing angle of 180°. The average of the data measured by drawing the adhesive tape at an angle of 180° was used as the measurement result and recorded.

### Tensile strength test

Test specimens with a width of 25 mm and a length of 150 mm were prepared from the belts prepared in the Examples, with 5 test specimens for each Example. The test specimen was clamped by a test jig. The test was configured to be performed at a tester speed of 50 mm/min and a drawing angle of 180°. The maximum tensile force at which the material was broken was recorded, and the maximum tensile force values were averaged to obtain the tensile strength of the material.

The values of peeling strength and tensile strength of Examples 1-10 and Comparative Examples 1-3 are as shown in the table below.

| Experimental group | Peeling strength (gf/25mm) | Tensile strength (MPa) |
|---|---|---|
| Example 1 | 183 | 189 |
| Example 2 | 192 | 302 |
| Example 3 | 195 | 296 |
| Example 4 | 191 | 295 |
| Example 5 | 190 | 292 |
| Example 6 | 265 | 226 |
| Example 7 | 259 | 231 |
| Example 8 | 262 | 245 |
| Example 9 | 235 | 208 |
| Example 10 | 228 | 201 |
| Comparative Example 1 | - (no substrate, no peeling test performed) | 45 |
| Comparative Example 2 | 55 | 183 |
| Comparative Example 3 | 192 | 195 |

As can be seen from Example 1 and Comparative Example 2 in the above table, after building the metal lithium transition layer on the copper foil substrate, the peeling strength of the lithium carbon composite belt was increased from 55 gf/25 mm to 183 gf/25 mm. Thus, the transition layer can significantly increase the adhesion of the lithium carbon layer on the copper foil substrate. Also, as can be seen from the data of the tensile strength test for Example 1, Example 2, Example 3, Example 4 and Comparative Example 1, the lithium carbon belt itself had a relatively low tensile strength, which was only 45 MPa, while after the lithium carbon belt was rolled onto a copper foil or an organic polymer substrate (such as polyethylene terephthalate and polyacrylonitrile), the material had a significantly increased tensile strength, and was suitable for the requirements of industrial production.

The belts prepared in Example 1, Comparative Example 2 and Comparative Example 3 were respectively used as a negative electrode, and assembled with a lithium iron phosphate positive electrode into a button cell. A Celgard 2500 type PP film was used as the separator. A solution of 1 M LiPF₆ in a mixed solvent of EC and EMC (in a volume ratio of 3:7) was used as the electrolyte solution. The assembled cell was subjected to a charging and discharging test in a test voltage range of 2.2-3.8 V at a charging/discharging current of 0.5 C. The test curves are as shown in Fig. 8.

As can be seen from Fig. 8, after cycling to around 85 weeks, the discharging capacity of the cell assembled with the material of Comparative Example 3 (which was prepared with a pure metal lithium) decayed sharply, and the cell life ended; the cell assembled with the lithium carbon material had a significantly prolonged cycle life. Although a lithium carbon material was used in Comparative Example 2, the substrate was not well bound with the lithium carbon material because of the direct binding of the lithium carbon material with the substrate, resulting in decayed performance of the lithium carbon material. This may be related to the internal resistance of the material. The materials were not well bound with each other, resulting in increased internal resistance, so that the decay rate of the cycle life of the cell was accelerated. The cell assembled with the material of Example 1 had the longest cycle life.

It can be understood that although the lithium carbon material and a preparation method therefor according to the present application are described in detail with reference to particular embodiments in the examples of the present application, the above description is presented only for the purpose of satisfying legal requirements, and the present application is not limited to the particular examples. The lithium carbon material and the preparation method therefor can be reproduced by those skilled in the art through proper operations according to the disclosure and teaching of the specification.

Proper modifications and variations can be made on the above embodiments by those skilled in the art according to the disclosure and teaching of the specification above. Therefore, the present application is not limited to the particular embodiments as disclosed and described above, and certain modifications and variations on the present application should also fall within the protection scope of the claims of the present application. Furthermore, although some particular terms are used in the specification, those terms are only for the purpose of description, but not intended to limit the present application in any way.

## Claims

1. A lithium carbon composite belt, **characterized in that** the lithium carbon composite belt comprises:
a conductive substrate,
a metal lithium transition layer on at least one side of the substrate, and
a lithium carbon composite material layer on an outer side of the metal lithium transition layer, wherein the lithium carbon composite material comprises a porous carbonaceous skeleton and metal lithium filled in pores of the porous carbonaceous skeleton, and a mass fraction of carbon in the lithium carbon composite material layer is in a range from 5% to 90%.

2. The lithium carbon composite belt according to claim 1, **characterized in that** the substrate is a metal foil, an organic polymer film, an inorganic material film or any composite film thereof.

3. The lithium carbon composite belt according to claim 2, **characterized in that** the metal foil is a foil obtained from aluminum, copper, nickel, tin, platinum, gold, silver, iron, lead, titanium, indium, zinc, magnesium, beryllium, tungsten, sodium, antimony or any combination thereof;
the organic polymer film is a film prepared from a polyolefin, a polyester, or a modified polymer containing one or more functional groups selected from the group consisting of amino, carboxyl, hydroxyl, imino, halogen, sulfo, nitro, mercapto, phenyl, and cyano;
the inorganic material film comprises a film obtained from an inorganic carbon material, a metal oxide, a metal halide, a metal nitride, a metal sulfide, a metal salt or any combination thereof; and
the composite film comprises a polyacrylonitrile film plated with copper on a surface thereof, a copper foil plated with an oxide on a surface thereof, a copper mesh plated with silver on a surface thereof, or a stainless steel mesh plated with lithium on a surface thereof.

4. The lithium carbon composite belt according to claim 1, **characterized in that** the lithium carbon composite belt meets at least one of the following conditions:
the substrate has a thickness in a range from 1 µm to 20 µm and a porosity in a range from 0% to 85%;
the metal lithium transition layer has a thickness in a range from 20 nm to 5 µm; and
the lithium carbon composite material layer has a thickness in a range from 1 µm to 200 µm.

5. The lithium carbon composite belt according to claim 1, **characterized in that** the porous carbonaceous skeleton of the lithium carbon composite material is a network skeleton having a lithiophilic modification layer, formed by intertwining a carbon composite material, wherein the carbon composite material comprises a crystalline carbonaceous material and an amorphous carbonaceous wrapping layer covering a surface of the crystalline carbonaceous material, and the amorphous carbonaceous wrapping layer forms the lithiophilic modification layer.

6. The lithium carbon composite belt according to claim 5, **characterized in that**
the crystalline carbonaceous material comprises one or more selected from the group consisting of carbon nanotubes, graphene, pyrolytic carbon fibers, graphite, soft carbon, hard carbon, mesocarbon microspheres, and carbon black;
the amorphous carbonaceous wrapping layer is a carbonized product of an organic material blended with the crystalline carbonaceous material, wherein the organic material is selected from the group consisting of an organic binder, an organic filler, and a crosslinker,
the amorphous carbonaceous coating layer has a thickness in a range from 10 nm to 600 nm, and
optionally, the amorphous carbonaceous wrapping layer further comprises metal nanoparticles embedded therein or on a surface thereof, wherein the metal nanoparticles have a size in a range from 5 nm to 800 nm.

7. The lithium carbon composite belt according to claim 1, **characterized in that**
the porous carbonaceous skeleton in the lithium carbon composite material layer has a linear, spherical, urchin-shaped, porous spherical, spheroidal or flat structure.

8. The lithium carbon composite belt according to claim 1, **characterized in that**
the mass fraction of carbon in the lithium carbon composite material layer is in a range from 15% to 65%.

9. A method for preparing the lithium carbon composite belt according to any one of claims 1 to 8, **characterized in that** the method is carried out under an inert gas atmosphere, and comprises:
Step I: pretreating a substrate, including subjecting the substrate to at least one of degreasing, pre-oxidizing, plasma purging, ultrasonic cleaning and high temperature treatment;
Step II: building a metal lithium transition layer, including building the metal lithium transition layer on a surface of the substrate by rolling, doctor blade coating, extrusion coating, physical vapor deposition, electroplating, or thermal evaporation deposition; and
Step III: building a lithium carbon composite material layer, including combining a lithium carbon composite material with the metal lithium transition layer by doctor blade coating, extrusion coating, or pressure binding, so as to obtain the lithium carbon composite belt.

10. The method according to claim 9, **characterized in that** the inert gas comprises argon or helium.

11. The method according to claim 9, **characterized in that** the lithium carbon composite material is prepared by:
Step 1: mixing an organic binder, a filler, a crosslinker and a solvent uniformly to obtain a mixture, wherein the filler comprises a crystalline carbonaceous material, an organic filler and optionally an inorganic filler;
Step 2: pre-drying the mixture obtained in Step 1 to remove the solvent;
Step 3: heating the material obtained in Step 2 under an inert atmosphere at a temperature in a range from 300°C to 1200°C and then cooling the material to obtain a porous carbonaceous skeleton; and
Step 4: impregnating the porous carbonaceous skeleton obtained in Step 3 with molten lithium to obtain a lithium carbon composite material;
wherein
a mass ratio of the organic binder, the filler, the crosslinker and the solvent is 4-15: 10-30: 0.01-20: 20-400,
a mass proportion of the crystalline carbonaceous material in the filler is in a range from 15% to 100%;
the organic binder is selected from the group consisting of polyvinyl alcohol, polyvinylidene fluoride, polybutylene styrene, polystyrene, polycarboxycellulose, cyanoacrylates, polyacrylic acid, cyclodextrins, cyclic ether derivatives, polyurethanes, methacrylates, epoxy resins, vinyl acetate polymer, polyimides, organic fluoropolymers, organosiloxanes, polyethylene glycol, polyethylene, polyvinyl chloride, polypropylene, glycerin, ethylparaben and its derivatives, and monosaccharide or polysaccharide polymers;
the organic filler is selected from the group consisting of plastic microparticles, benzoic acid, sodium benzoate, sorbic acid, potassium sorbate, calcium propionate, and dehydroacetates;
the inorganic filler is selected from the group consisting of metal nanoparticles, metal oxides, metal nitrides, calcium carbonate, hydrous magnesium silicate, mica, hydrated silica, and silica;
the crosslinker is selected from the group consisting of macromolecular polymers of acrylic acid bonded with allyl sucrose or pentaerythritol allyl ether, benzoyl peroxide, diethylenetriamine, sodium borate hydrate, cellulose derivatives, and isothiazolinone; and
the solvent is selected from the group consisting of water, tetrachloroethylene, toluene, turpentine, acetone, methyl acetate, ethyl acetate, pentane, n-hexane, cyclohexane, octane, lemonile, alcohol, xylene, toluene, cyclohexanone, isopropyl alcohol, diethyl ether, propylene oxide, methyl butanone, ethylene glycol monomethyl ether, ethylene glycol monoethyl ether, ethylene glycol monobutyl ether, acetonitrile, pyridine, phenol, and ethylenediamine.
